# EUROPEAN PATENT SPECIFICATION

(11) **EP 0 342 039 B1**
(45) Date of publication and mention of the grant of the patent: **31.08.1994**
(21) Application number: 89304791.0
(22) Date of filing: 11.05.1989
(51) Int. Cl.: H01L 39/22

(54) **Josephson device and method of making same**
Josephson-Einrichtung und Verfahren zu ihrer Herstellung
Dispositif Josephson et procédé pour sa fabrication

(30) Priority: 11.05.1988 JP 112649/88
(43) Date of publication of application: 15.11.1989
(73) Proprietor: CANON KABUSHIKI KAISHA, Tokyo (JP)
(72) Inventor: Yamamoto, Keisuke, Atsugi-shi Kanagawa-ken (JP); Tanaka, Atsuko, Machida-shi Tokyo (JP); Shinjyo, Katsuhiko, Atsugi-shi Kanagawa-ken (JP)
(74) Representative: Beresford, Keith Denis Lewis

(56) References cited:
- EP-A- 0 285 132
- PATENT ABSTRACTS OF JAPAN vol. 13, no. 186 (E-752)(3534) 2 May 1989, & JP-A-1 12585

## Description

### BACKGROUND OF THE INVENTION

### Field of the invention

The present invention relates to a Josephson device comprising a metal oxide superconductor which can be operated at a relatively high temperature, and to a method of making it.

### Related Background Art

Josephson junction devices of a tunnel type are widely used in electronic devices such as SQUID, photodetectors, and switching devices.

Conventional tunnel-type Josephson junction devices have employed niobium (Nb) or lead (Pb), or Nb compounds or Pb compounds as the superconductive material used in the first and second superconductive layers thereof. Also, the tunneling layer thereof has been formed by subjecting an oxide of a superconductive oxide material to a high frequency plasma oxidation treatment.

Recently ceramics have been found that exhibit a superconductive state at temperatures above than the boiling point of the liquid nitrogen. These ceramics are oxides of a Y-Ba-Cu-O type and those of a Bi-Sr-Ca-Cu-O type.

High-temperature superconductors comprise an oxide material, having a complicated crystal structure. Such oxide superconductors can be formed into thin films by means of electron beam heating or magnetron sputtering. However, in order for the oxide superconductors to exhibit the superconduction, the quantity of oxygen in the compound is required to be stoichiometric or closely stoichiometric. A thin film deficient in oxygen is formed when the film formation is carried out in a reducing atmosphere as in electron beam heating or magnetron sputtering. Accordingly, in order to impart superconductivity to a thin film prepared by such a film-forming process, it has been necessary to carry out heating in an oxygen atmosphere at 800 to 900°C. In an alternative method for obtaining superconductivity without heating to such high temperatures, it has been proposed to provide a substrate maintained at 650°C or more and to make the partial pressure of O₂ higher. However, the amount of impurities in the resulting superconductive film becomes increased and a film having good characteristics is not obtained,

Thus, when a high temperature heating step is included in the preparation of a tunnel-type Josephson device, the problem arises that the tunneling layer becomes diffused, and first and second superconductive films with good characteristics are not obtained. Furthermore, if the partial pressure of O₂ is increased, the problem also arises that the superconductive films are contaminated with impurities.

Moreover, employment in a tunneling layer of materials having different crystal structure from the superconductive layers, can result in very poor crystallizability of the upper, second superconductive layer. For this reason, no tunnel-type Josephson junction devices have been realized that employ a high temperature superconductor (ceramic superconductor) in the first and second superconductive layers and have a good sandwich-type junction.

### SUMMARY OF THE INVENTION

On problem with which the present invention is concerned is to provide a tunnel-type Josephson junction device in which the problems of non-uniformity in thickness of the junction layer and poor crystallizability of superconductive layers are alleviated, a good sandwich-type junction is obtained, and good characteristics are exhibited.

Another problem with which the present invention is concerned is to provide a simple method for preparing a tunnel-type Josephson junction device, which can produce devices having good characteristics even without heating to high temperature.

To achieve the above objects, the present invention provides a Josephson device, comprising a substrate, a first superconductive layer, a tunneling layer and a second superconductive layer which are laminated in this order, wherein said tunneling layer comprises a metal oxide having the same constituent elements as these of a metal oxide superconductor which forms said first and second superconductive layers, and the oxygen content of the metal oxide is less than that of the metal oxide superconductor.

In a preferred embodiment, the present invention provides a Josephson device, comprising a substrate, a first superconductive layer, a tunneling layer and a second superconductive layer which are laminated in this order, wherein said first and second superconductive layers each comprise a metal oxide superconductor represented by the compositional formula: Y₁Ba₂Cu₃O_{7-δ} (0 ≦ δ < 0.5), and said tunneling layer comprises a metal oxide represented by the compositional formula: Y₁Ba₂Cu₃O_{7-δ} (δ > 0.5)

The present invention also provides a method of preparing a Josephson device, comprising forming on the surface of a substrate a first superconductive layer, a tunneling layer and a second superconductive layer which are laminated in this order by ion beam deposition and high frequency plasma oxidation treatment used in combination, wherein said high frequency plasma oxidation treatment is carried out under conditions which differ between the step of forming said first and second superconductive layers and the step of forming said tunneling layer.

In a preferred embodiment of the method, the present invention further provides a method of preparing a Josephson device, comprising forming on the surface of a substrate a first superconductive layer, a tunneling layer and a second superconductive layer in this order by ion beam deposition and high frequency plasma oxidation treatment used in combination, wherein said high frequency plasma oxidation treatment is carried out under conditions which differ between the step of forming said first and second superconductive layers and the step of forming said tunneling layer, thereby forming said first and second superconductive layers which comprise a metal oxide superconductor, and forming said tunneling layer which comprises a metal oxide having the same constituent elements as these of said metal oxide superconductor and the oxygen content of which is less than that of said metal oxide superconductor.

In another preferred embodiment of the method, the present invention provides a method of preparing a Josephson device, comprising forming on the surface of a substrate a first superconductive layer, a tunneling layer and a second superconductive layer in this order, wherein said first and second superconductive layers are formed by ion beam deposition and high frequency plasma oxidation treatment used in combination, and said tunneling layer is formed by ion beam deposition.

In still another preferred embodiment of the method, the present invention provides a method of preparing a Josephson device, comprising forming on the surface of a substrate a first superconductive layer, a tunneling layer and a second superconductive layer in this order, wherein said first and second superconductive layers comprising a metal oxide superconductor are formed by ion beam deposition and high frequency plasma oxidation treatment used in combination, and said tunneling layer which comprises a metal oxide having the same constituent elements as those of said metal oxide superconductor and the oxgen content of which is less than that of said metal oxide superconductor is formed by ion beam deposition.

### BRIEF DESCRIPTION OF THE DRAWINGS

Fig. 1 schematically illustrates an apparatus used in the method of the present invention;
Fig. 2 shows an X-ray diffraction pattern of a Y-Ba-Cu-O thin film;
Fig. 3 shows a temperature-resistance curve of the Y-Ba-Cu-O thin film;
Fig. 4 illustrates a construction of a tunnel-type Josephson junction device prepared in the present invention; and
Fig. 5 shows current-voltage characteristics of a tunnel-type Josephson junction device prepared in the present invention.

### DETAILED DESCRIPTION OF THE PREFERRED EMBODIMENTS

The high temperature superconductor (a ceramic superconductor) turns to have a superconductive phase when the quantity of oxygen is close to the stoichiometric quantity, and, on the other hand, turns to have an insulating phase when it deviates from the stoichiometric quantity, in other words, when oxygen is deficient.

The present inventors found that utilizing the phase transformation as described above makes it possible to use a metal oxide having the same composition (the same constituent elements) in both the layers of the superconductive layer and tunneling layer of the above tunnel-type Josephson junction device, and this makes it possible to prepare a tunnel-type Josephson junction device with a good crystallizability of superconducive layers and also form a thin and uniform tunneling layer, thus providing a tunnel-type Josephson junction device having good characteristics.

First, the tunnel-type Josephson junction device of the present invention is a tunnel-type Josephson junction device comprising a substrate, a first superconductive layer, a tunneling layer and a second superconductive layer which are laminated in this order, characterized in that the first and second superconductive layers comprise a metal oxide superconductor containing oxygen in the stoichiometric quantity or a quantity close thereto, and at the same time the above tunneling layer has the same composition as that of the above metal oxide superconductor but comprises a metal oxide deficient in the quantity of oxygen.

In the present invention, the metal oxide superconductor that may be preferably used as the first and second superconductive layers includes Y-Ba-Cu-O superconductors represented by the compositional formula: Y₁Ba₂Cu₃O_{7-δ} (0 ≦ δ < 0.5).

In the present invention, the metal oxides that may be preferably used as the tunneling layer includes insulators represented by the compositional formula: Y₁Ba₂Cu₃O_{7-δ} (δ > 0.5).

The above first and second superconductive layers may preferably be made to each have a layer thickness of from 200 nm to 500 nm; and the tunneling layer, a film thickness of from 1 nm to 50 nm.

The substrate may comprise an MgO singlecrystal, an SrTi0₃ singlecrystal, etc., which are preferably used.

The preparation method of the present invention will be described below.

The method of preparing the Josephson device of the present invention comprises forming on the surface of a substrate the first superconductive layer, the tunneling layer and the second superconductive layer in this order by ion beam deposition and high frequency plasma oxidation treatment used in combination, characterized in that said high frequency plasma oxidation treatment is carried out under conditions which differ, to continuously carry out the formation of said first and second superconductive layers and tunneling layer.

Here, the "high frequency plasma oxidation treatment is carried out under conditions made different" can be considered to be achievable by a method of;upon preparating the tunneling layer, (1) changing the high frequency power used in the high frequency plasma oxidation treatment; or (2) changing the flow rate of oxygen gas in the high frequency plasma oxidation treatment.

In the above method (1), the high frequency power may be appropriately decreased or may be completely turned off, so that the content of oxygen in the tunneling layer formed can be made smaller than that in the superconductive layers.

In the above method (2), the flow rate per unit time, of the oxygen gas flowing into a film formation chamber may be appropriately decreased or may be replaced with a oxygen gas mixed with argon, carbon tetrafluoride, chlorine or the like, so that the density of the oxygen gas held in the film formation chamber can be decreased.

The preparation method of the present invention will be further detailed below with reference to the drawing that illustrates a preferred embodiment thereof.

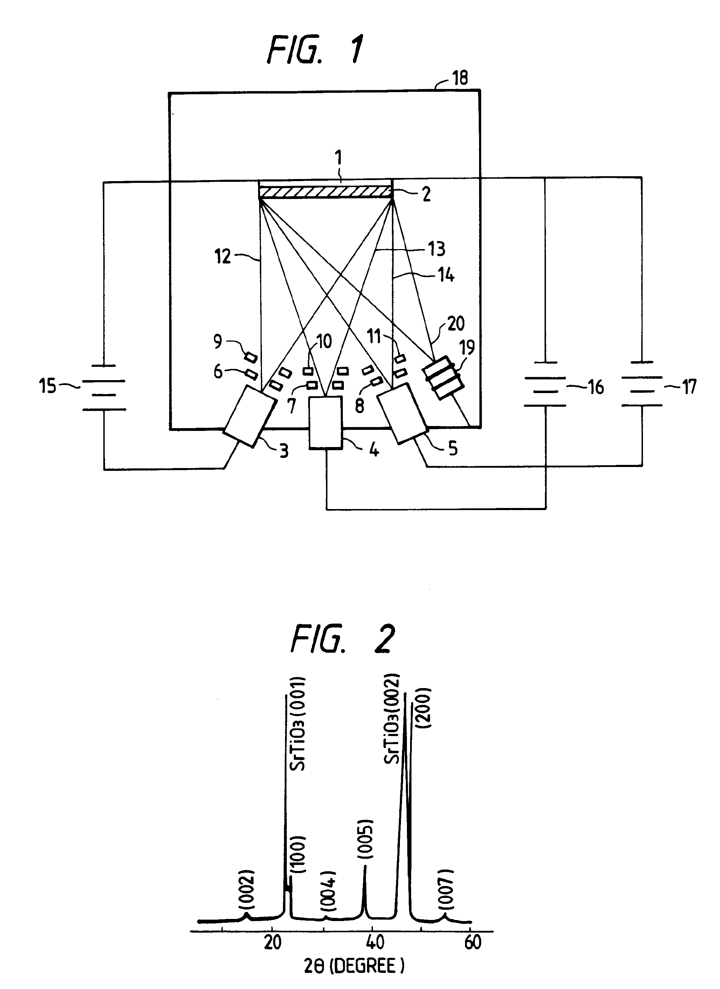

Fig. 1 schematically illustrates a deposition apparatus used in the method of the present invention. In Fig. 1, the numeral 1 denotes a substrate; 2, a thin film formed, with a three-layer structure of superconductive layer/tunneling layer/superconductive layer; 3, 4 and 5, crucibles, in which materials to be vaporized are put; 6, 7 and 8, ionizing units to ionize the vapors of the vaporizing materials left from the crucibles; 9, 10 and 11, accelerating electrodes to increase the velocity of the vapors ionized by the ionizing units; and 12, 13 and 14, ion beams of the vapors generated. The numerals 15, 16 and 17 denote accelerating electric sources to increase the velocity of the vapors. In this embodiment, the substrate potential is set at the earth potential, and the accelerating electrode potential can be accelerated up to about 10 kV. The numeral 18 denotes a vacuum chamber. The numeral 19 denotes a high frequency plasma generation source; and 20, a gas ion beam. The temperature of the substrate 1, the temperature of the crucibles 3, 4 and 5, the ionizing electric currents in the ionizing units 6, 7 and 8, the gas flow rate in the high frequency plasma generation source 19, the high frequency power, and the accelerating voltage can be independently controllable by corresponding units (not shown).

In the present invention, using the above apparatus, the constituent elements of the ceramic superconductor are independently vaporized from the crucibles 3, 4 and 5, oxygen gas ion beams are generated from the high frequency plasma generation source, and the deposition and oxidation are simultaneously carried out. Thus, the deposition carried out while generating the high frequency plasma can more accelerate the oxidation of thin films. In this way, superconductive thin films with sufficiently good characteristics can be obtained even without any heat treatment. In addition, conditions such as the high frequency power, kind of gases and gas flow rate of the high frequency plasma generation source may be appropriately selected, and thereby the ceramic superconductor containing oxygen in the stoichiometric quantity or a quantity close thereto and the insulator containing oxygen in a quantity deviating from the stoichiometric quantity can be freely prepared.

In the present invention, utilizing this action, the first ceramic superconductive layer is first formed on the substrate, and, after this layer is deposited, conditions such as the high frequency power, kind of gases and gas flow rate of the high frequency plasma generation source are immediately changed to form the tunneling layer, which serves as the insulating layer. Thereafter, conditions such as the high frequency power, kind of gases and gas flow rate of the high frequency plasma generation source are again immediately controlled to form the second ceramic superconductive layer, so that the three-layer structure of the tunnel-type Josephson junction device can be formed in, one process, from the same kind of materials.

As described above, according to the present invention, the film formation method in which the ion beam deposition and high frequency plasma source are used in combination enables the formation of the metal oxide superconductive thin film with sufficiently good characteristics, even without heat treatment at high temperature of 650 °C or more. Moreover, conditions of the high frequency plasma source are appropriately changed, and thereby the insulator (the tunneling layer) also can be formed, in the same process, from the same materials, so that the thin films, having the structure of superconductive layer/tunneling layer/superconductive layer can also be formed in one process of vacuum deposition. Thus, it has become possible to readily prepare the tunnel-type Josephson junction device that employs the high temperature superconductor, which has not been hitherto realized.

Moreover, the tunnel-type Josephson junction device prepared by the preparation method of the present invention comprises the superconductive layers and tunneling layer having compositionally the same constitution, so that it has a good sandwich-type junction, giving a tunnel-type Josephson junction device with superior characteristics.

The present invention will be described below in greater detail by giving Examples.

### EXAMPLE 1

Materials of Y₁Ba₂Cu₃O_{7-δ} (0 ≦ δ < 0.5) with an oxygen content close to the stoichiometric quantity were selected as materials for the first and second superconductive layers, and a material of Y₁Ba₂Cu₃O_{7-δ} (δ > 0.5) with an oxygen content deviated from the stoichiometric quantity, as a material for the tunneling layer.

Using the apparatus shown in Fig. 1, Cu, Ba and Y as vaporizing sources were put in the crucibles 3, 4 and 5, respectively, SrTiO₃ was used as the substrate, and the substrate temperature was set at 350°C. The degree of vacuum in the vacuum chamber 18 was so controlled as to be 266,5.10⁻⁶ Pa (2 x 10⁻⁶ Torr), and oxygen gas of the high frequency plasma source was fed from an inlet (not shown in Fig. 1) at a rate of 9 to 12 ml/min to the chamber. The ionizing electric currents for the components Y, Ba and Cu were set to 50 mA, 100 mA and 100 mA, respectively; the accelerating voltages therefor, to 0.5 kV, 4 kV and 4kV, respectively; and the high frequency power and accelerating voltage of the high frequency plasma source, to 300 W and 0.3 kV, respectively. The temperatures of the crucibles 3, 4 and 5 were controlled, so as to give substantially Y:Ba:Cu = 1:2:3 on the substrate. Here, the rate of vaporization was 0.2 to 0.3 nm/sec.

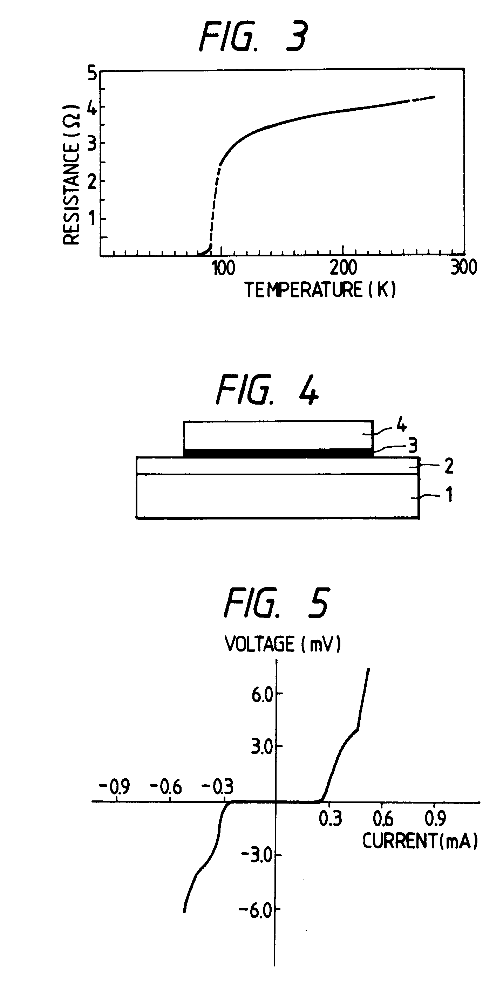

The first superconductive layer thus prepared was taken out in the course of the processing, and X-ray diffraction was carried out to obtain the pattern as shown in Fig. 2. The superconductive characteristics were also examined to obtain the temperature-resistance curve as shown in Fig. 3. It was thereby confirmed that the electrical resistance of the above superconductive layer droped to zero at about 86 K. In this way, it was possible to form the superconductive layer without any heat treatment. Then, after the superconductive layer was formed, the oxygen-deficient tunneling layer was formed with a thickness of about 3 nm under the same conditions except that the high frequency power and accelerating voltage of the high frequency plasma source were set to 0 W and 0 V, respectively. Thereafter, the high frequency power and accelerating voltage were again set to 300 W and 0.3 kV, respectively, to similarly deposit the second superconductive layer on the above tunneling layer. Using the thin film thus prepared, of the structure of superconductive layer/tunneling layer/superconductive layer, a tunnel-type Josephson junction device of the present invention, as illustrated in Fig. 4, was prepared according to a conventional photolithographic technique. In Fig. 4, the numeral 1 denotes the substrate; 2, the first superconductive layer; 3, the tunneling layer ; and 4, the second superconductive layer.

In the present Example, the numeral 1 denotes an SrTiO₃ substrate; 2, a Y₁Ba₂Cu₃O₇ superconductive layer with an oxygen content close to the stoichiometric quantity; 3, a Y₁Ba₂Cu₃O_{7-δ} (δ > 0.5) oxygen-deficient tunneling layer; and 4, Y₁Ba₂Cu₃O₇ superconductive layer with an oxygen content close to the stoichiometric quantity. The electrical characteristics of the tunnel-type Josephson junction device of the present invention, thus prepared, were examined to find that the current-voltage characteristics as shown in Fig. 5 were obtained at about 60 K. It was seen therefrom that a good tunnel-type Josephson junction device has been formed.

### Example 2

The first superconductive layer was formed under the same conditions as in Example 1, but the temperature of the substrate was set at 400°C and the flow rate of an oxygen gas was set at 10 to 15 ml/min. and the ionizing currents and accelerating voltages for Y, Ba and Cu were set at 0 mA, 0 kV; 100 mA, 5 kV; and 100 mA, 2 kV, respectively. Immediately thereafter the kind of the gas used as the high frequency plasma source was changed to replace the oxygen gas alone used with a mixed gas comprising oxygen gas and argon gas in the proportion of 1 : 3, to form the tunneling layer. Here, the film formation was carried out setting the high frequency power and accelerating voltage of the high frequency plasma source, to 300 W and 0.3 kV, respectively. Thereafter the second superconductive layer was formed in the same manner as in Example 1, and a tunnel-type Josephson junction device of the present invention, as illustrated in Fig. 4, was prepared according to a conventional photolithographic technique. This device showed the same current-voltage characteristic as those shown in Fig. 5, at about 65 K.

### Example 3

The first superconductive layer was formed under the same conditions as in Example 1, and thereafter the kind of the gas used as the high frequency plasma source was changed to replace the oxygen gas alone used with a 1:1 mixed gas of oxygen gas and argon gas, setting the high frequency power and accelerating voltage to 100 W and 0.3 kV, respectively, to form the tunneling layer. Thereafter the second superconductive layer was formed in the same manner as in Example 1, and a tunnel-type Josephson junction device of the present invention, as illustrated in Fig. 4, was prepared according to a conventional photolithographic technique. This device showed the same current-voltage characteristics as those shown in Fig. 5, at about 75 K.

In the present Example, the Y-Ba-CU-O type superconductive material was used as the material, but the Josephson device can be similarly formed even with use of superconductive materials of other type of oxides or oxides that contain fluorine, where the same effect as Examples can be obtained by so controlling film formation conditions as to be optimum, without limition to Examples.

## Claims

1. A Josephson device (Fig 4), comprising a substrate (1) a first superconductive layer (2), a tunneling layer (3) and a second superconductive layer (4) which are laminated in this order, wherein the tunneling layer (3) comprises a metal oxide having the same constituent elements as those of a metal oxide superconductor which forms the first and second superconductive layers (2,4) and the oxygen content of the metal oxide is less than that of the metal oxide superconductor.

2. The Josephson device according to Claim 1, wherein the metal oxide comprises an insulator.

3. The Josephson device according to Claim 1 or 2, wherein the first and second superconductive layers (2,4) each have a layer thickness of from 200 nm to 500 nm.

4. The Josephson device according to Claim 1, wherein the tunneling layer (3) has a layer thickness of from 1 nm to 50 nm.

5. A Josephson device according to any preceding claim, wherein the first and second superconductive layers (2,4) each comprise a metal oxide superconductor represented by the compositional formula:
Y₁Ba₂Cu₃0_{7-δ} (0 ≦ δ < 0.5),
and said tunneling layer (3) comprises a metal oxide represented by the compositional formula:
Y₁Ba₂Cu₃0₇₋ (δ > 0.5).

6. A method of preparing a Josephson device according to any of claims 1-5, comprising forming on the surface of a substrate (1) a first superconductive layer (2), a tunneling layer (3) and a second superconductive layer (4) in this order by a combination of ion beam deposition and high frequency plasma oxidation wherein the conditions under which the plasma oxidation, is carried out differ between the step of forming the first and second superconductive layers and the step of forming the tunneling layer.

7. A method of preparing a Josephson device according to any of claims 1-5, comprising forming on the surface of a substrate (1) a first superconductive layer (2), a tunneling layer (3) and a second superconductive layer (4) in this order, wherein said first and second superconductive layers (2,4) are formed by ion beam deposition and high frequency plasma oxidation treatment used in combination, and said tunneling layer (3) is formed by ion beam deposition.

8. The method according to Claim 6, wherein the high frequency plasma oxidation is carried out at a power that differs between the step of forming the first and second superconductive layers (2,4) and the step of forming the tunneling layer (3).

9. The method according to Claim 6, wherein the rapid frequency plasma oxidation is carried out at an oxygen gas flow rate that differs between the step of forming said first and second superconductive layers (2,4) and the step of forming said tunneling layer (3).

10. The method according to any of Claims 6 to 9, wherein the formation of said first supercondive layer (2), said tunneling layer (3) and said second superconductive layer (4) is carried out continuously.

11. The method of any of Claims 6 to 10, wherein said metal oxide superconductor is represented by the compositional formula: Y₁Ba₂Cu₃O_{7-δ} (0 ≦ δ < 0.5) and the metal oxide is represented by the compositional formula: Y₁Ba₂Cu₃O_{7-δ} (δ > 0.5).

## Patentansprüche

1. Josephson-Vorrichtung (Fig. 4), umfassend ein Substrat (1), eine erste supraleitende Schicht (2), eine Tunnel-Schicht (3) und eine zweite supraleitende Schicht (4), die in dieser Reihenfolge laminiert sind, wobei die Tunnel-Schicht (3) ein Metalloxid mit denselben bestandteilbildenden Elementen wie bei dem Metalloxid-Supraleiter, der die erste und die zweite supraleitende Schicht (2, 4) bildet, umfaßt und wobei der Sauerstoffgehalt des Metalloxids niedriger als der des Metalloxid-Supraleiters ist.

2. Josephson-Vorrichtung nach Anspruch 1, wobei das Metalloxid einen Isolator umfaßt.

3. Josephson-Vorrichtung nach einem der Ansprüche 1 oder 2, wobei die erste und zweite supraleitende Schicht (2, 4) jeweils eine Schichtdicke von 200 nm bis 500 nm haben.

4. Josephson-Vorrichtung nach Anspruch 1, wobei die Tunnel-Schicht (3) eine Schichtdicke von 1 nm bis 50 nm hat.

5. Josephson-Vorrichtung nach einem der vorhergehenden Ansprüche, wobei die erste und zweite supraleitende Schicht (2, 4) jeweils einen Metalloxid-Supraleiter, dargestellt durch die Summenformel:
Y₁Ba₂Cu₃O_{7-δ} (0 ≦ δ < 0,5),
umfassen, und die Tunnel-Schicht (3) ein Metalloxid, dargestellt durch die Summenformel:
Y₁Ba₂Cu₃O_{7-δ} (δ > 0,5)
umfaßt.

6. Verfahren zur Herstellung einer Josephson-Vorrichtung nach einem der Ansprüche 1 bis 5, das auf der Oberfläche eines Substrats (1) die Bildung einer ersten supraleitenden Schicht (2), einer Tunnel-Schicht (3) und einer zweiten supraleitenden Schicht (4) in dieser Reihenfolge durch eine Kombination von Ionenstrahl-Bedampfung und Hochfrequenz-Plasmaoxidation umfaßt, wobei sich die Bedingungen, unter denen die Plasmaoxidation ausgeführt wird, zwischen dem Schritt zur Bildung der ersten und zweiten supraleitenden Schicht und dem Schritt zur Bidung der Tunnel-Schicht unterscheiden.

7. Verfahren zur Herstellung einer Josephson-Vorrichtung nach einem der Ansprüche 1 bis 5, das auf der Oberfläche eines Substrats (1) die Bildung einer ersten supraleitenden Schicht (2), einer Tunnel-Schicht (3) und einer zweiten supraleitenden Schicht (4) in dieser Reihenfolge umfaßt, wobei die erste und zweite supraleitende Schicht (2, 4) durch Ionenstrahl-Bedampfung und Hochfrequenz-Plasmaoxidationsbehandlung, die in Kombination verwendet werden, gebildet werden und die Tunnel-Schicht (3) durch Ionenstrahl-Bedampfung gebildet wird.

8. Verfahren nach Anspruch 6, wobei die Hochfrequenz-Plasmaoxidation bei einer Leistung ausgeführt wird, die sich zwischen dem Schritt zur Bildung der ersten und zweiten supraleitenden Schicht (2, 4) und dem Schritt zur Bildung der Tunnel-Schicht (3) unterscheidet.

9. Verfahren nach Anspruch 6, wobei die Hochfrequenz-Plasmaoxidation bei einer Sauerstoff-Flußrate durchgeführt wird, die sich zwischen dem Schritt zur Bildung der ersten und zweiten supraleitenden Schicht (2, 4) und dem Schritt zur Bildung der Tunnel-Schicht (3) unterscheidet.

10. Verfahren nach einem der Ansprüche 6 bis 9, wobei die Bildung der ersten supraleitenden Schicht (2), der Tunnel-Schicht (3) und der zweiten supraleitenden Schicht (4) kontinuierlich durchgeführt wird.

11. Verfahren nach einem der Ansprüche 6 bis 10, wobei der Metalloxid-Supraleiter durch die Summenformel: Y₁Ba₂Cu₃O_{7-δ}, (0 ≦ δ < 0,5) dargestellt wird und das Metalloxid durch die Summenformel: Y₁Ba₂Cu₃O_{7-δ}, (δ > 0,5) dargestellt wird.

## Revendications

1. Un dispositif Josephson (figure 4), comprenant un substrat (1), une première couche supraconductrice (2), une couche à effet tunnel (3) et une seconde couche supraconductrice (4) qui sont superposés dans cet ordre, dans lequel la couche à effet tunnel (3) consiste en un oxyde métallique ayant les mêmes éléments constitutifs qu'un supraconducteur à oxyde métallique qui forme les première et seconde couches supraconductrices (2, 4), et en ce que la teneur en oxygène de l'oxyde métallique est inférieure à celle du supraconducteur à oxyde métallique.

2. Le dispositif Josephson selon la revendication 1, dans lequel l'oxyde métallique consiste en un isolant.

3. Le dispositif Josephson selon la revendication 1 ou 2, dans lequel les première et seconde couches supraconductrices (2, 4) ont chacune une épaisseur de couche de 200 nm à 500 nm.

4. Le dispositif Josephson selon la revendication 1, dans lequel la couche à effet tunnel (3) a une épaisseur de couche de 1 nm à 50 nm.

5. Un dispositif Josephson selon l'une quelconque des revendications précédentes, dans lequel les première et seconde couches supraconductrices (2, 4) consistent chacune en un supraconducteur à oxyde métallique qui est représenté par la formule de composition :
Y₁Ba₂Cu₃0_{7-δ} (0 ≦ δ < 0,5),
et la couche à effet tunnel (3) consiste en un oxyde métallique qui est représenté par la formule de composition :
Y₁Ba₂Cu₃0_{7-δ} (δ > 0,5).

6. Un procédé de préparation d'un dispositif Josephson selon l'une quelconque des revendications 1-5, comprenant la formation sur la surface d'un substrat (1) d'une première couche supraconductrice (2), d'une couche à effet tunnel (3) et d'une seconde couche supraconductrice (4), dans cet ordre, par une combinaison de dépôt par faisceau d'ions et d'oxydation par plasma à haute fréquence, dans lequel les conditions dans lesquelles l'oxydation par plasma est effectuée ne sont pas les mêmes dans l'étape de formation des première et seconde couches supraconductrices et dans l'étape de formation de la couche à effet tunnel.

7. Un procédé de préparation d'un dispositif Josephson selon l'une quelconque des revendications 1-5, comprenant la formation, sur la surface d'un substrat (1), d'une première couche supraconductrice (2), d'une couche à effet tunnel (3) et d'une seconde couche supraconductrice (4), dans cet ordre, dans lequel les première et seconde couches supraconductrices (2, 4) sont formées par dépôt par faisceau d'ions et par un traitement d'oxydation par plasma à haute fréquence, utilisés en combinaison, et la couche à effet tunnel (3) est formée par dépôt par faisceau d'ions.

8. Le procédé selon la revendication 6, dans lequel l'oxydation par plasma à haute fréquence est effectuée à une puissance qui n'est pas la même dans l'étape de formation des première et seconde couches supraconductrices (2, 4) et dans l'étape de formation de la couche à effet tunnel (3).

9. Le procédé selon la revendication 6, dans lequel l'oxydation par plasma à haute fréquence est accomplie avec un débit de gaz consistant en oxygène qui n'est pas le même dans l'étape de formation des première et seconde couches supraconductrices (2, 4) et dans l'étape de formation de la couche à effet tunnel (3).

10. Le procédé selon l'une quelconque des revendications 6 à 9, dans lequel la formation de la première couche supraconductrice (2), de la couche à effet tunnel (3) et de la seconde couche supraconductrice (4) est accomplie de façon continue.

11. Le procédé de l'une quelconque des revendications 6 à 10, dans lequel le supraconducteur à oxyde métallique est représenté par la formule de composition Y₁Ba₂Cu₃0_{7-δ} (0 ≦ δ < 0,5), et l'oxyde métallique est représenté par la formule de composition : Y₁Ba₂Cu₃O_{7-δ} (δ>0,5).
